# EUROPEAN PATENT APPLICATION

(11) **EP 1 956 652 A1**
(43) Date of publication of application: **13.08.2008**
(21) Application number: 07102001.0
(22) Date of filing: 08.02.2007
(51) Int. Cl.: H01L 23/498, H01L 23/66, H05K 1/14, H01L 25/10, H01L 23/055

(54) **Sealed ball grid array package**

(71) Applicant: Nederlandse Organisatie voor Toegepast-Natuurwetenschappelijk Onderzoek TNO, 2628 VK Delft (NL)
(72) Inventor: Veninga, Erik Peter, 5673 LW Nuenen (NL)
(74) Representative: van Loon, C.J.J.

(57) **Abstract**

According to an aspect of the invention, there is provided an electrical package device comprising: a first substrate (2) and a second substrate (3) enclosing a first electric component (4), a second electric component (7) supported by said second substrate; a plurality of connectors (5) for mechanically connecting said first and second substrates in a stacked arrangement; and a seal (6) provided between said first and second substrates at a distance from said first electric component; wherein said first electric component is electrically connected to said second electric component by connecting circuitry comprising said connectors; and wherein said connectors are provided in said seal. Preferably, said seal comprises a no flow resin material.

## Description

### FIELD OF THE INVENTION

The invention relates to the field of packages for packaging one or more chips. In particular, the present invention relates to micro-electronics or Micro-electro-mechanical systems (MEMS) and devices that are assembled on substrates. The present invention also relates to a method of packaging such MEMS devices and systems.

### BACKGROUND OF THE INVENTION

Present micro-electric systems frequently use so called packages which are electrically connected to each other, for example, on a printed circuit board. The packages function as modular elements that are connectable, usually by soldering or glueing. The packages define a housing for one or more electrical components such as chips and supporting circuitry peripheral to the chips. A typical package material is Low-Temperature Co-Fired Ceramic ("LTCC") which is eligible due to it's strength and low thermal expansion properties. As such a so called functional System-in-a-Package can be provided. The package protects it's fragile system components and can more easily be integrated in larger electronic systems. In particular, the packages can be stacked structures, where a plurality of chips and/or electronic circuitry is provided on different stacked layers, which are electrically connected by circuitry that connect the stacked layers and thus form a electrical connection traversing the layers and connecting electrical components arranged on different layers. A package for micro-electronics or microsystems (MEMS) thus devised comprises mechanical and electric connections between several functional package-layers. Typically, a need arises for miniature solutions for packages, so that the cost of space in electric systems can be reduced. Moreover it is frequently necessary to protect sensitive parts of the package against disadvantageous influences from outside. A desire arises to provide a protective environment for the packaged components, without costing too much space. US2003/0020173 discloses a Radio Frequency (RF) Micro-electromechanical system (MEMS) that is fabricated on or within Low-Temperature Co-Fired Ceramic ("LTCC") substrates. The sealing and bonding of such packages is provided by resin or by hermetic solder layers. US2005087883 discloses a no flow underfill seal to provide mechanical stabilization of a chip on a substrate.

### SUMMARY OF THE INVENTION

According to an aspect of the invention, there is provided an electrical package device comprising: a first substrate comprising a first electric component; a second substrate comprising a second electric component, a plurality of connectors for mechanically connecting said first and second substrates in a stacked arrangement; and a seal provided between said first and second substrates at a distance from said first electric component; wherein said first electric component is electrically connected to said second electric component by connecting circuitry comprising said connectors; and wherein said connectors are provided in said seal. Preferably, said seal comprises a no flow resin material.

### BRIEF DESCRIPTION OF THE DRAWINGS

Figure 1 shows a side view impression of an electrical package device according to an aspect of the invention;
Figure 2 shows a detailed aspect view of a seal area of the package device according to an aspect of the invention; and
Figure 3 shows an example of a proces-flow for manufacture of the electrical package device according to an aspect of the invention.

### DETAILED DESCRIPTION OF EMBODIMENTS

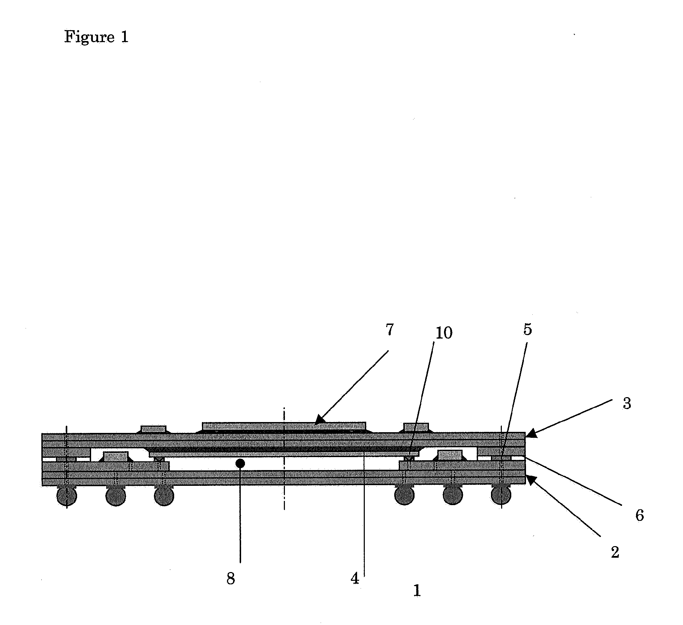

Figure 1 shows an embodiment according an aspect of the invention showing an electrical package 1. First substrate 2 is provided as a base substrate; second substrate 3 is provided as a top substrate. Note that the substrates are devised of stacked layers. First substrate 2 and second substrate 3 are providing a housing for an electrical component 4, in particular a radio frequency chip that is bonded to a lower side of the second substrate 3. This bonding can be a conventional bonding, for instance a resin type bonding or thermo-compression bonding.

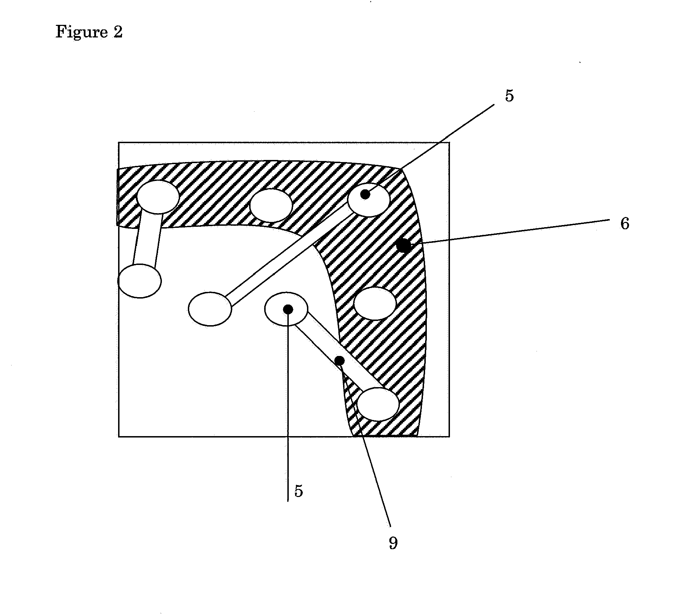

The chip 4 faces a cavity 8 which is provided on substrate 2 to provide a dielectric medium in front of the chip 4. The dielectric constant is about 1 and is provided to prevent malfunction of the radio frequency chip. The cavity-area spans about 0.2 - 0.3 mm but can varied accordingly. The chip 4 is electrically connected by connectors 10 to the lower substrate 2. These provide the driving signals for the radio frequency chip 4 from connecting circuitry provided through the base substrate 2 by interconnecting contacts 5 (see also figure 2). On top of substrate 3 a further electric component, in particular a flipchip-bonded chip 7 is provided. The chip 7 can be connected to radio frequency chip 4 or to circuitry (not shown) to be attached via a lower site of substrate 2 via connectors 5. The connectors 5 function in addition as a mechanical bond between substrate 2 and substrate 3. In this way a stacked arrangement is provided having a flipchip 7 bonded on a top of substrate 3 and a radio frequency chip 4 bonded to a lower site of substrate 3. The dimensions of the package 1 are typically about 10 X 10 mm having a height of about 3 mm and can be varied accordingly. The radio frequency chip 4 is protected by a seal 6 according to an aspect of the invention, which seal 6 is preferably of a no-flow underfill material none in the art. In this way connectors 5 providing mechanical en electrical connections are provided in the seal 6. Typically the connectors are formed by solder balls or bumps. This seal 6 is preferably matched to a thermal expansion coefficient of the substrate 2,3. However preferably the substrates 2 and 3 are formed of identical material so that a thermal mismatch will not arise and accordingly no further requirements relating to thermal expansion of the underfill material 6 are necessary.

The thermal expansion coefficients of the chips 4 and 7, in particular radio frequency chip 4 are preferably matched to the substrate 2 and 3, in particular so that no further mechanical stabilization of connectors 10 is necessary. This provides an advantage of keeping the seal 6 distanced from the cavity 8, so that a uniform dielectric is formed without a risk of a flow of seal material into the cavity 8. Typically matching thermal coefficients of substrate and chips are provided by a lowtemperature co-fired ceramic (LTCC) material of substrates 2 and 3 and a chip 4 provided as a GaAs chip. Other materials are feasible. The radio frequency chip 4 is preferably provided as a flipchip, that is, having the electrical connections e made directly to connectors 10 provided on substrate 2 and having an active side of the chip facing downward. Since a package seal 6 according to the invention is provided no further sealing is necessary inside package. Additionally a thick film AuPt (Pd-Ag) may be provided on a top layer package to facilitate Au bonding for a chip an solder bonding for example with solder types SnPb37 or SnAgCu in the sealing. The chip interconnection structure maybe provided by laser structuring the thick film.

Figure 2 shows a detailed aspect view of the seal area 6 of the package device 1 showing in figure 1, in particular a seal area 6 having connectors 5 provided in the seal 6. The connectors provided electrical and mechanical connections according to an aspect of the invention. Interconnections 9 provide electrical interconnection in the plane of substrate 2.

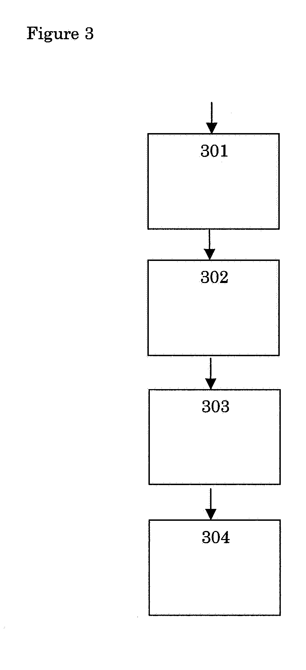

Figure 3 is an example of process-flow for the manufacturing a package according to an aspect of the invention. According to an aspect of the invention, the inventive seal can be provided in a single process step that provides the electrical interconnection between the package substrates. Thus the inventive method can be easily integrated in conventional manufacturing steps.

In particular, there are provided that steps of
301 providing a first substrate comprising a plurality of solder spheres;
302 providing a second substrate covered with an underfill seal;
303 pressing said solder spheres into the underfill seal; and
304 soldering said first substrate to said second substrate while curing said underfill.

In one aspect, the invention provides a possibility for providing a quasi hermetically sealed package that is as thin as 3 mm, and that has a footprint as small as 10 mm x 10 mm; which package may be provided on a organic or ceramic substrate material.

It is noted that a no-flow underfill seal is conventionally known as an alternative to resin type seals, to provide mechanical stabilisation of a chip on a substrate. According to an aspect of the invention, however the package sealing is preferably provided between materials having matching thermal expansion coefficients, in contrast to the common applications where the underfill seal is used to comply with mismatching thermal expansion coefficients. In addition, an underfill seal is conventionally known for sealing chips, where according to the invention, the sealing is provided on a different level of system integration; that is, not the chip integration, but the manufacturing of a package.

While the invention has been illustrated with a no flow underfill type seal, alternatively first and second substrate parts may be soldered to each other and a seal may be provided on the outside of the soldered connection. Also, alternative electrical connections between the package parts (for instance, of a ceramic type) may be provided, including electrical conductive adhesives or the like. Further alternative mechanical connections may be further provided by glass, solder or epoxy. An advantage of inventive solution is that miniature modular packaging is made feasible. In addition, the packages may be (hermetically) sealed to at least protect the inner circuitry from moist and dirt. It may be preferably to adjust and tune the sealing material to match thermal expansion coefficients with the substrate. Also, the flow characteristic of the seal may be tuned, in particular, by adapting a fluxcomponent of the underfill.

While the invention has been illustrated and described in detail in the drawings and foregoing description, such illustration and description are to be considered illustrative or exemplary and not restrictive; the invention is not limited to the disclosed embodiments. Furthermore, the skilled person will appreciate that the term radio frequency used herein is not limited to a specified frequency range in the electromagnetic spectrum, but may encompass all kinds of radiation frequencies, including the radar and/or microwave frequencies.

Other variations to the disclosed embodiments can be understood and by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single unit may fulfill the functions of several items recited in the claims. The mere fact that certain measures are recited in mutually different dependent claims does not indicate that a combination of these measured cannot be used to advantage. Any reference signs in the claims should not be construed as limiting the scope.

## Claims

1. An electrical package device (1) comprising:
- first and second substrates (2,3); said first and second substrates (2,3) enclosing a first electric component (4) and said second substrate (3) supporting a second electric component (7) on a top side facing away from said first substrate (2);
- a plurality of connectors (5) for mechanically connecting said first and second substrates (2,3) in a stacked arrangement; and
- a seal (6) provided between said first and second substrates (2,3) at a distance from said first electric component (4); wherein
- said second electric component (7) is electrically connected to said connectors (5); and wherein
- said connectors (5) are provided in said seal (6);

2. An electrical package according to claim 1, wherein said seal comprises a no flow resin material.

3. An electrical package according to claim 1, wherein said connectors are formed by soldered balls.

4. An electrical package according to claim 1, wherein said first electric component comprises an integrated circuit (4) bonded to one of said first and second substrates; and circuit connectors electrically connecting said integrated circuit to the other of said first and second substrates; the circuit connectors (10) provided distanced from said seal.

5. An electrical package according to claim 4, wherein said integrated circuit comprises a radio frequency chip (4) and wherein a cavity (8) is provided in said other of said first and second substrates (2,3) to provide a dielectic for said radio frequency chip.

6. An electrical package according to claim 1, wherein said substrates (2,3) are formed of a material having a thermal expansion coefficient matching with the first electric component.

7. An electrical package according to claim 6, wherein said first and second substrates are formed by a low temperature cofired ceramic ("LTCC") material and wherein said first electric component comprises a Ga As chip.

8. A method of providing a sealed electrical package comprising:
- providing a first substrate comprising a plurality of solder spheres;
- providing a second substrate covered with an underfill seal;
- pressing said solder spheres into the underfill seal; and
- soldering said first substrate to said second substrate while curing said underfill seal.
